# EUROPEAN PATENT APPLICATION

(11) **EP 2 555 406 A1**
(43) Date of publication of application: **06.02.2013**
(21) Application number: 11762519.4
(22) Date of filing: 09.03.2011
(51) Int. Cl.: H02M 7/48

(54) **MOTOR DRIVE CIRCUIT MODULE**

(30) Priority: 29.03.2010 JP 2010075743
(71) Applicant: Honda Motor Co., Ltd., Minato-ku Tokyo 107-8556 (JP)
(72) Inventor: SEKI, Shinsei, Wako-shi Saitama 351-0193 (JP)
(74) Representative: Feller, Frank
(86) International application number: PCT/JP2011/055503
(87) International publication number: WO 2011/122279

(57) **Abstract**

In the disclosed motor-driving circuit module, a first electrode surface of a first electrode and a third electrode surface of a third electrode are arranged so as to face each other and such that current flows in opposite directions in the first electrode and the third electrode when a current runs through the first electrode. Also, a second electrode surface of a second electrode and the third electrode surface of the third electrode are arranged so as to face each other and such that current flows in opposite directions in the second electrode and the third electrode when a current runs through the second electrode.

## Description

### TECHNICAL FIELD

The present invention relates to a motor drive circuit module.
Priority is claimed on Japanese Patent Application No. 2010-075743, filed March 29, 2010, the contents of which are incorporated herein by reference.

### BACKGROUND ART

In motor drive circuit modules used to drive a motor, the inductance of the wiring of a drive circuit causes a rise in surge voltage in a case where a switching device is switched to supply a motor driving current to a motor from a power source. If the surge voltage is high, power loss is incurred, and if the surge voltage exceeding the withstand voltage of the switching device is applied, degradation of the switching device is caused. In order to suppress this, applying currents in mutually opposite directions at the same time to further reduce inductance by a mutual inductance effect is performed.

### Documents of the prior art

### Patent Documents

Patent Document 1: Japanese Unexamined Patent Application, First Publication No. 2005-261035

### DISCLOSURE OF INVENTION

### Problems to be solved by the invention

However, since the switching device is horizontally set in the above related-art motor drive circuit modules, there is a problem in that the inductance cannot be sufficiently reduced.

Thus, an object of the invention is to provide a motor drive circuit module that can reduce the inductance effectively using the mutual inductance effect.

### Means for solving the problem

In order to achieve the above object, the invention has adopted the following:
(1) One aspect of the present invention provides a motor drive circuit module provided in a power control unit that has a first electrode line connected to one electrode of a power source and a second electrode line connected to the other electrode of the power source and drives a motor with the electric power from the power source, and arranged between the first electrode line, the second electrode line, and the motor. The module includes, inside a resin mold portion in which switching devices are molded, a first electrode connected to the first electrode line; a second electrode connected to the second electrode line; and a third electrode connected to the motor. A first electrode surface of the first electrode and a third electrode surface of the third electrode are arranged so as to face each other and such that currents flow in opposite directions in the first electrode and the third electrode when a current flows through the first electrode, and a second electrode surface of the second electrode and the third electrode surface of the third electrode are arranged so as to face each other and such that currents flow in opposite directions in the second electrode and the third electrode when a current flows through the second electrode.

(2) In the motor drive circuit module described in the above (1), a configuration may be adopted in which inductance offset portions are provided where the distance between the first electrode surface and the third electrode surface and the distance between the second output electrode surface and the third electrode surface are partially smaller than other portions, in a portion where the first electrode surface of the first electrode and the third electrode surface of the third electrode face each other and a portion where the second electrode surface of the second electrode and the third electrode surface of the third electrode face each other.

(3) The motor drive circuit module described in the above (2) may further include insulating materials interposed between the first electrode surface of the first electrode and the third electrode surface of the third electrode and between the second electrode surface of the second electrode and the third electrode surface of the third electrode, which correspond to the inductance offset portions.

### Effects of Invention

According to the aspect described in the above (1), the first electrode surface of the first electrode and the third electrode surface of the third electrode face each other, the second electrode surface of the second electrode and the third electrode surface of the third electrode face each other, and currents flow in opposite directions. Therefore, the inductance can be effectively reduced by mutual inductance.
In the case described in the above (2), the inductance can be further reduced by providing the inductance offset portions where the distance between the first electrode surface of the first electrode and the third electrode surface of the third electrode surface and the distance between the second electrode surface of the second electrode and the third electrode surface of the third electrode becomes smaller.
In the case described in the above (3), the insulating materials are provided, so that the distance between the first electrode surface of the first electrode and the third electrode surface of the third electrode and the distance between the second electrode surface of the second electrode and the third electrode surface of the third electrode can be minimized and the inductance can be minimized.

### Brief Description of the Drawings

FIG. 1 is a circuit diagram of a motor drive circuit device in one embodiment of the invention;
FIG. 2 is a perspective view of a motor drive circuit module in the embodiment;
FIG. 3 is an exploded perspective view of the motor drive circuit module;
FIG. 4 is a circuit diagram of the motor drive circuit module;
FIG. 5 is a cross-sectional view of the motor drive circuit module;
FIG. 6 is a graph showing changes in a surge voltage during switching in the embodiment and showing a situation where the surge voltage is suppressed;
FIG. 7 is a view showing a motor drive circuit module in another embodiment of the invention, and is a cross-sectional view corresponding to FIG. 5; and
FIG. 8 is a graph showing the relationship between inter-electrode distance and the mutual inductance effect in the embodiment.

### EMBODIMENTS FOR CARRYING OUT THE INVENTION

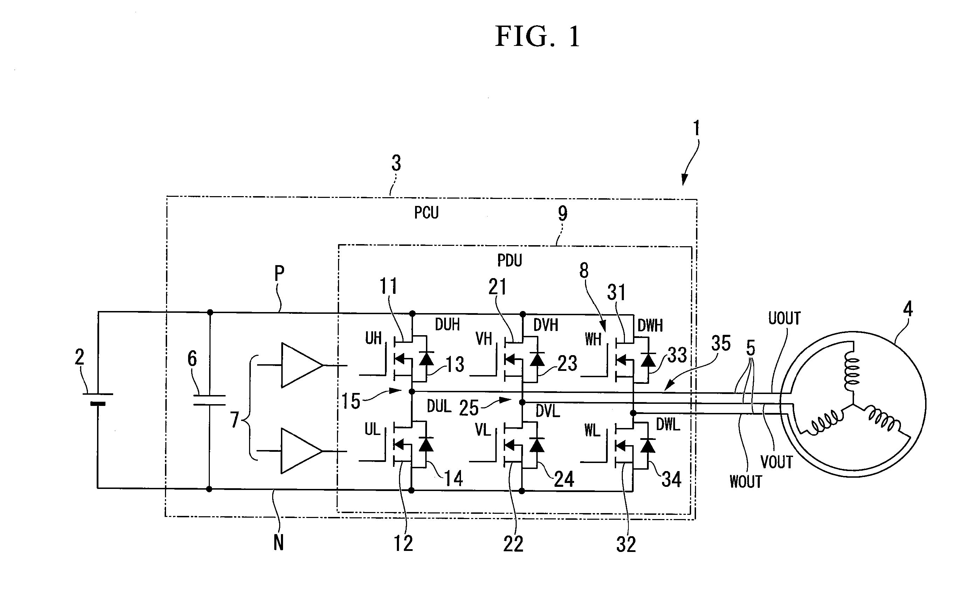

Embodiments of the invention will be described below with reference to the accompanying drawings. FIG. 1 shows the configuration of a circuit 1 including a power control unit (PCU) of a hybrid vehicle related to one embodiment of the invention. The circuit 1 includes a battery 2 of a high-voltage type, a power control unit 3, and a motor 4. In the hybrid vehicle, for example, an engine and the motor 4 directly connected to this engine are arranged in the engine room. The power control unit 3 and the battery 2 are arranged in a rear part of the cabin of the hybrid vehicle. The motor 4 and the power control unit 3 are mutually connected by a three-phase cable 5.

A positive electrode line P of the power control unit 3 is connected to a positive electrode of the battery 2, and a negative electrode line N of the power control unit 3 is connected to a negative electrode of the battery 2. Thereby, electric power is supplied to the power control unit 3 from the battery 2, and the motor 4 is driven in a state where the electric power voltage of the power control unit 3 is raised. In a case where the motor 4 performs a regenerative operation, the electric power voltage of the power control unit 3 is lowered, and the battery 2 is charged by the positive electrode line P and the negative electrode line N. The power control unit 3 is constituted by a power drive unit (PDU) 9. The power drive unit (PDU) 9 includes a smoothing capacitor 6, a gate drive substrate 7, and a bridge circuit 8.

The bridge circuit 8 of the power drive unit 9 is configured so as to bridge-connect a high-side (high-potential-side) U-phase switching device (UH) 11, a low-side (low-potential-side) U-phase switching device (UL) 12, and a high-side V-phase switching device (VH) 21, and a low-side V-phase switching device (VL) 22, a high-side W-phase switching device (WH) 31, and a low-side W-phase switching device (WL) 32. Here, the high-side U-phase switching device (UH) 11 and the low-side U-phase switching device (UL) 12 are connected using wiring, and the wiring is connected to the U-phase of a three-phase cable 5. The high-side V-phase switching device (VH) 21 and the low-side V-phase switching device (VL) 22 are connected using wiring, and the wiring is connected to the V phase of the three-phase cable 5. The high-side W-phase switching device (WH) 31 and the low-side W-phase switching device (WL) 32 are connected using wiring, and the wiring is connected to the W phase of the three-phase cable 5. Here, as the switching devices, transistors, FETs (Field-effect Transistors), IGBTs (Insulated Gate Bipolar Transistors), or the like are used.

The high-side U-phase switching device 11, the high-side V-phase switching device 21, and the high-side W-phase switching device 31 that are high-side switching devices are connected to the positive electrode line P, and these devices constitute a high-side arm. The low-side U-phase switching device 12, the low-side V-phase switching device 22, and the low-side W-phase switching device 32 that are low-side switching devices are connected to the negative electrode line N, and these devices constitute a low-side arm.

An example in which bipolar transistors are used as the switching devices is shown. A diode (DUH) 13, a diode (DUL) 14, a diode (DVH) 23, a diode (DVL) 24, a diode (DWH) 33, and a diode (DWL) 34 are connected, so as to arrange a forward direction from an emitter toward a collector between the collector and the emitter of each of the switching devices 11, 12, 21, 22, 31, and 32.
The bridge circuit 8 and U-phase, V-phase, and W-phase coils of the motor 4 are connected by the three-phase cable 5. The three-phase cable 5 is constituted by three electrode lines of a third U electrodes line UOUT, a third V electrode line VOUT, and a third W electrode line WOUT.
Here, in a case where the motor 4 is made to perform a regenerative operation, if a current flows into the third U electrode line UOUT, the third V electrode line VOUT, and the third W electrode line WOUT, descriptions of not only symbol "OUT" but also symbol "IN" should also be made. However, only the description of "OUT" is used as the designation of respective parts to avoid complications.

Here, the high-side U-phase switching device 11, the low-side U-phase switching device 12, the diode 13, and the diode 14 are integrally molded as a U-phase motor drive circuit module 15 from resin. The high-side V-phase switching device 21, the low-side V-phase switching device 22, the diode 23, and the diode 24 are integrally molded as a V-phase motor drive circuit module 25 from resin. The high-side W-phase switching device 31, the low-side W-phase switching device 32, the diode 33, and the diode 34 are integrally molded as a W-phase motor drive circuit module 35 from resin.
Accordingly, the U-phase motor drive circuit module 15, the V-phase motor drive circuit module 25, and the W-phase motor drive circuit module 35 are arranged between the positive electrode line P, the negative electrode line N, and the motor 4.

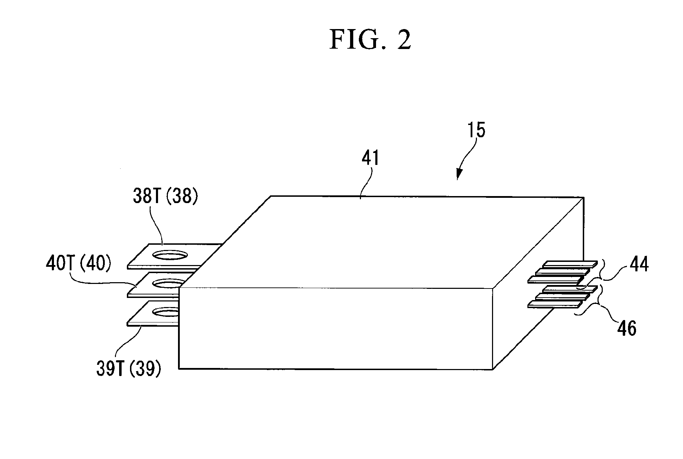

FIG. 2 is a perspective view of a motor drive circuit module in the embodiment of the present invention.

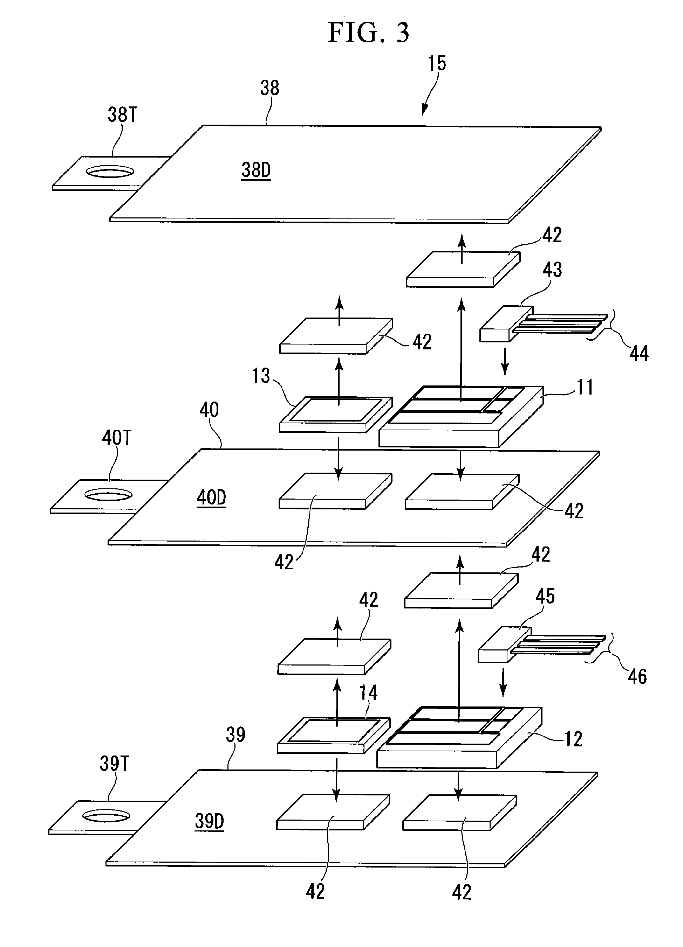

FIG. 3 shows an exploded perspective view of the U-phase motor drive circuit module 15. In addition, since the V-phase motor drive circuit module 25 and the W-phase motor drive circuit module 35 also have the same configurations as the U-phase motor drive circuit module 15, descriptions thereof will be omitted.

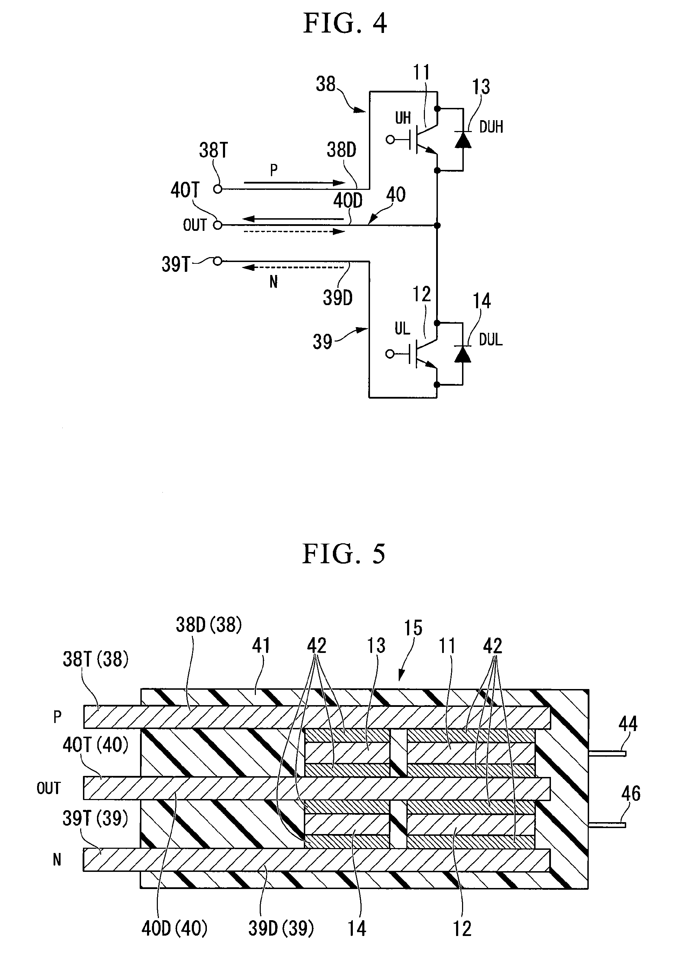

FIG. 4 is a circuit diagram of the motor drive circuit module. FIG. 5 is a cross-sectional view of the motor drive circuit module. As shown in FIGS. 2 to 5, in the U-phase motor drive circuit module 15, an upper positive electrode 38 connected to the positive electrode line P, a lower negative electrode 39 connected to the negative electrode line N, and an OUT electrode 40 that is arranged between the positive electrode 38 and the negative electrode 39 and connected to the third U electrode line UOUT are stacked so as to overlap each other as seen from the top face. These are molded by a resin mold portion 41. In addition, reference numerals 38T, 39T, and 40T represent the terminal areas of the positive electrode 38, the negative electrode 39, and the OUT electrode 40, respectively, and protrude to the outside of the resin mold portion 41.

As shown in FIG. 3, the high-side U-phase switching device 11, the diode 13, and a signal terminal 43 are mounted together between the positive electrode 38 and the OUT electrode 40 via a solder layer 42 inside the resin mold portion 41. A signal line 44 of the signal terminal 43 protrudes to the outside of the resin mold portion.
The low-side U-phase switching device 12, the diode 14, and a signal terminal 45 are mounted between the OUT electrode 40 and the negative electrode 39 via a solder layer 42 inside the resin mold portion 41. A signal line 46 of the signal terminal 45 also protrudes to the outside of the resin mold portion 41.

Only the resin mold portion 41 is interposed between the positive electrode 38 and the OUT electrode 40 and between the OUT electrode 40 and the negative electrode 39 in the portion where the high-side U-phase switching device 11 and the diode 13, and the low-side U-phase switching device 12 and the diode 14 are not arranged, inside the resin mold portion 41. In that portion, a positive electrode surface 38D of the positive electrode 38 and an OUT electrode surface 40D of the OUT electrode 40 face each other, and the OUT electrode surface 40D of the OUT electrode 40 and a negative electrode surface 39D of the negative electrode 39 face each other.
Additionally, as shown in FIG. 4, the positive electrode 38, the OUT electrode 40, and the negative electrode 39 are arranged so that the direction of a current that flows through the positive electrode 38 and the direction of a current that flows through the OUT electrode 40 reverses direction (solid line arrow) when the current flows through the positive electrode 38. Moreover, an arrangement is made so that the direction of a current that flows through the negative electrode 39 and the direction of the current that flows through the OUT electrode 40 reverses direction (broken line arrow) when the current flows through the negative electrode 39.

According to the above embodiment, as shown in FIG. 5, within the resin mold portion 41, the positive electrode surface 38D of the positive electrode 38 and the OUT electrode surface 40D of the OUT electrode 40 face each other and the OUT electrode surface 40D of the OUT electrode 40 and the negative electrode surface 39D of the negative electrode 39 face each other. Also, an arrangement is made so that currents flow in opposite directions in the positive electrode 38 and the OUT electrode 40 when a current flows through the positive electrode 38 (solid line of FIG. 4), and an arrangement is made so that currents flow in opposite directions in the negative electrode 39 and the OUT electrode 40 when a current flows through the negative electrode 39 (broken line of FIG. 4). Therefore, the inductance can be effectively reduced by the mutual inductance effect.

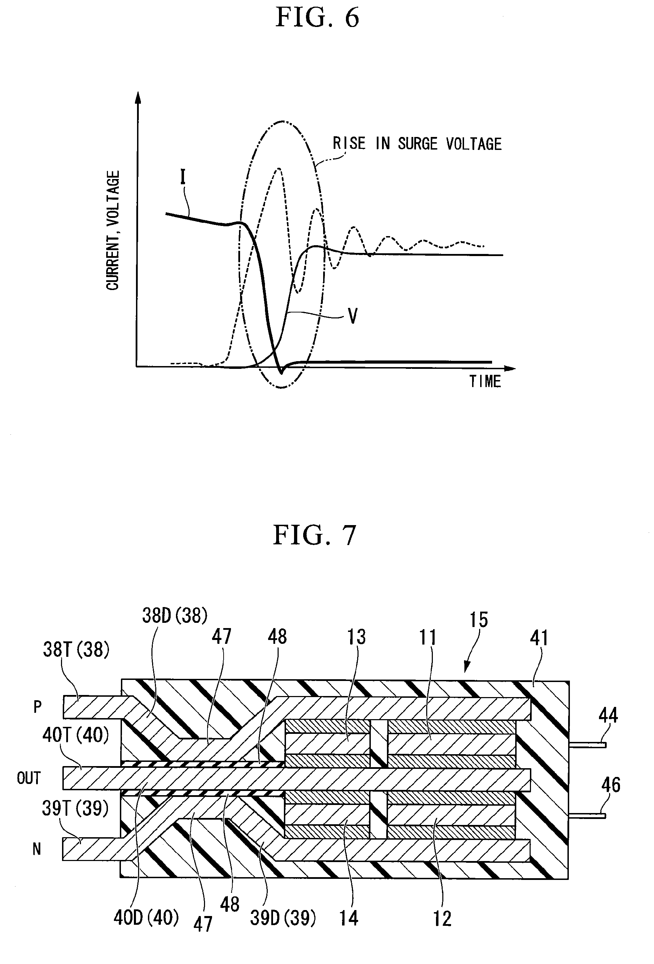

FIG. 6 shows an example of the switching waveform of a related-art driving module and the switching waveform of the drive module in the embodiment of the present invention. The vertical axis shows a relative voltage value and a relative current value. The horizontal axis shows time.
In a case where an arrangement where the positive electrode 38 and the OUT electrode 40 do not face each other but extend in separate directions like the related art is adopted (in a case where the OUT electrode 40 extends to the right side referring to FIG. 5), the inductance of wiring is generated in proportion to the distance between the positive electrode terminal 38T and the OUT electrode terminal 40T, and if a current I (solid line) decreases abruptly during a switching operation, a rise (chain line in FIG. 6) in a surge voltage whose voltage rises up abruptly occurs. In contrast, according to the embodiment of the present invention, the rise in this surge voltage can be suppressed as a voltage V shown by a solid line, loss and withstand voltage over (application of a voltage exceeding the withstand voltage of the switching devices) of the switching devices, or the like can be prevented.

That is, if the positive electrode surface 38D of the positive electrode 38 and the OUT electrode surface 40D of the OUT electrode 40 in FIG. 5 are taken as an example, mutual induction occurs as the positive electrode surface 38D and the OUT electrode surface 40D are arranged to face each other. Thereby, since an induced electromotive force determined by mutual inductance is generated if a current flows through the positive electrode surface 38D of the positive electrode 38, and is mutually offset by an induced electromotive force determined by the mutual inductance produced by a current that flows to the OUT electrode surface 40D of the OUT electrode 40 in a direction opposite to the current of the positive electrode surface 38D (mutual inductance effect), the overall inductance can be reduced as a result.

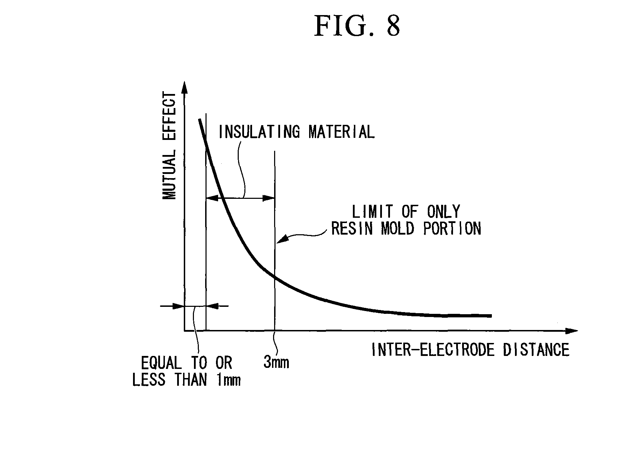

Next, another embodiment of the present invention will be described with reference to FIGS. 7 and 8.
As shown in FIG. 7, in this embodiment, an inductance offset portion 47 where the distance between the positive electrode surface 38D of the positive electrode 38 and the OUT electrode surface 40D of the OUT electrode 40 is partially smaller than the other portions, and an inductance offset portion 47 where the distance between the OUT electrode surface 40D of the OUT electrode 40 and the negative electrode surface 39D of the negative electrode 39 is partially smaller than the other portions are provided, in the positive electrode surface 38D of the positive electrode 38 and the OUT electrode surface 40D of the OUT electrode 40, and the OUT electrode surface 40D of the OUT electrode 40 and the negative electrode surface 39D of the negative electrode 39, which face each other in the first embodiment. Specifically, the middle portions of the positive electrode surface 38D and the OUT electrode surface 40D in the right-and-left direction of FIG. 7 approaches the OUT electrode surface 40D and the inductance offset portion 47 close to the OUT electrode surface 40D is formed.

Also, insulating materials 48 are interposed between the positive electrode surface 38D of the positive electrode 38 and the OUT electrode surface 40D of the OUT electrode 40 and between the OUT electrode surface 40D of the OUT electrode 40 and the negative electrode surface 39D of the negative electrode 39, which correspond to the inductance offset portions 47. Specifically, the insulating materials 48 are provided so as to cover the top and bottom surfaces of the OUT electrode surface 40D of the OUT electrode 40.

Accordingly, in this embodiment, the distance between the positive electrode surface 38D of the positive electrode 38 and the OUT electrode surface 40D of the OUT electrode 40 and the distance between the OUT electrode surface 40D of the OUT electrode 40 and the negative electrode surface 39D of the negative electrode 39 can be minimized by providing the insulating materials 48. Thus, the mutual inductance can be increased to make the overall inductance low.

That is, as shown in FIG. 8, the inter-electrode distance and the mutual inductance effect have an inverse proportion relationship. However, in a case where the insulating materials 48 are not provided (only the resin mold portion is provided), the inter-electrode distance, whose limit was, for example, about 3 mm in order to prevent short circuiting, can be less than or equal to 1 mm by adding the insulating materials 48. This enables a range with a large mutual effect to be used.
In addition, the present invention is not limited only to the above embodiments and can be applied to vehicles that use a motor, such as an electric vehicle and a fuel cell vehicle, for a traveling driving force in addition to hybrid vehicles.

### INDUSTRIAL APPLICABILITY

A motor drive circuit module that can reduce the inductance effectively by mutual inductance can be provided.

### Description of Reference Symbols

- 2: BATTERY (POWER SOURCE)
- P: POSITIVE ELECTRODE LINE (FIRST ELECTRODE LINE)
- N: NEGATIVE ELECTRODE LINE (SECOND ELECTRODE LINE)
- 4: MOTOR
- 3: POWER CONTROL UNIT
- 15: U-PHASE MOTOR DRIVE CIRCUIT MODULE
- 25: V-PHASE MOTOR DRIVE CIRCUIT MODULE
- 35: W-PHASE MOTOR DRIVE CIRCUIT MODULE
- 11: HIGH-SIDE U-PHASE SWITCHING DEVICE
- 12: LOW-SIDE U-PHASE SWITCHING DEVICE
- 21: HIGH-SIDE V-PHASE SWITCHING DEVICE
- 22: LOW-SIDE V-PHASE SWITCHING DEVICE
- 31: HIGH-SIDE W-PHASE SWITCHING DEVICE
- 32: LOW-SIDE W-PHASE SWITCHING DEVICE
- 41: RESIN MOLD PORTION
- 38: POSITIVE ELECTRODE (FIRST ELECTRODE)
- 39: NEGATIVE ELECTRODE (SECOND ELECTRODE)
- 40: OUT ELECTRODE (THIRD ELECTRODE)
- 38D: POSITIVE ELECTRODE SURFACE (FIRST ELECTRODE SURFACE)
- 39D: NEGATIVE ELECTRODE SURFACE (SECOND ELECTRODE SURFACE)
- 40D: OUT ELECTRODE SURFACE (THIRD ELECTRODE SURFACE)
- 47: INDUCTANCE OFFSET PORTION
- 48: INSULATING MATERIAL

## Claims

1. A motor drive circuit module provided in a power control unit that has a first electrode line connected to one electrode of a power source and a second electrode line connected to the other electrode of the power source and drives a motor with the electric power from the power source, and arranged between the first electrode line, the second electrode line, and the motor, the module comprising:
inside a resin mold portion in which switching devices are molded,
a first electrode connected to the first electrode line;
a second electrode connected to the second electrode line; and
a third electrode connected to the motor,
wherein a first electrode surface of the first electrode and a third electrode surface of the third electrode are arranged so as to face each other and such that currents flow in opposite directions in the first electrode and the third electrode when a current flows through the first electrode, and
wherein a second electrode surface of the second electrode and the third electrode surface of the third electrode are arranged so as to face each other and such that currents flow in opposite directions in the second electrode and the third electrode when a current flows through the second electrode.

2. The motor drive circuit module according to claim 1,
wherein inductance offset portions where the distance between the first electrode surface and the third electrode surface and the distance between the second output electrode surface and the third electrode surface are partially smaller than other portions are provided, in a portion where the first electrode surface of the first electrode and the third electrode surface of the third electrode face each other and a portion where the second electrode surface of the second electrode and the third electrode surface of the third electrode face each other.

3. The motor drive circuit module according to claim 2, further comprising:
insulating materials interposed between the first electrode surface of the first electrode and the third electrode surface of the third electrode and between the second electrode surface of the second electrode and the third electrode surface of the third electrode, which correspond to the inductance offset portions.

## Amended claims

### Amended claims under Art. 19.1 PCT

**1.** (Currently Amended) A motor drive circuit module provided in a power control unit that has a first electrode line connected to one electrode of a power source and a second electrode line connected to the other electrode of the power source and drives a motor with the electric power from the power source, and arranged between the first and second electrode lines, and the motor, the module comprising, inside a resin mold portion in which a first switching device and a second switching device are molded:
a first electrode connected to the first electrode line;
a second electrode connected to the second electrode line; and
a third electrode connected to the motor,
wherein a first electrode surface of the first electrode and a third electrode surface of the third electrode are arranged so as to face each other and such that currents flow in opposite directions in the first electrode and the third electrode when a current flows through the first electrode, and
wherein a second electrode surface of the second electrode and the third electrode surface of the third electrode are arranged so as to face each other and such that currents flow in opposite directions in the second electrode and the third electrode when a current flows through the second electrode,
wherein the first switching device that is arranged between the first electrode and the third electrode and electrically connected to the first electrode and the second electrode and the second switching device that is arranged between the second electrode and the third electrode and electrically connected to the second electrode and the third electrode are stacked.

**2.** The motor drive circuit module according to claim 1,
wherein inductance offset portions where the distance between the first electrode surface and the third electrode surface and the distance between the second output electrode surface and the third electrode surface are partially smaller than other portions are provided, in a portion where the first electrode surface of the first electrode and the third electrode surface of the third electrode face each other and a portion where the second electrode surface of the second electrode and the third electrode surface of the third electrode face each other.

**3.** The motor drive circuit module according to claim 2, further comprising:
insulating materials interposed between the first electrode surface of the first electrode and the third electrode surface of the third electrode and between the second electrode surface of the second electrode and the third electrode surface of the third electrode, which correspond to the inductance offset portions.

Statement under Art. 19.1 PCT
With respect to claim 1, an amendment has been made by adding a feature that a switching device and electrodes, which are described in paragraphs [0016]-[0020] and shown in FIGS. 2-5, are stacked and molded to reduce inductance.

In the Written Opinion of the International Searching Authority issued concerning the present patent application, the added feature is not described in any references cited by the international search report, and thus the added feature is not obvious to a person skilled in the art.

Therefore, based on the Written Opinion of the International Search Authority, the invention described in the claims 1, 2, and 3 after the amendment should be regarded as having both novelty and an inventive step.
